# EUROPEAN PATENT APPLICATION

(11) **EP 3 104 180 A1**
(43) Date of publication of application: **14.12.2016**
(21) Application number: 15460020.9
(22) Date of filing: 08.06.2015
(51) Int. Cl.: G01R 1/04, G01R 15/14, G01R 21/06, G01R 22/06, H01R 13/66, H01R 24/76, H01R 25/00

(54) **A DEVICE FOR MONITORING ELECTRIC PARAMETERS OF ELECTRIC LOAD**

(71) Applicant: ABB Technology AG, 8050 Zürich (CH)
(72) Inventor: Ludowski, Pawel, 31-867 Krakow (PL); Ryba, Piotr, 36-206 (PL); Wasacz, Jerzy, 30-227 Krakow (PL)
(74) Representative: Chochorowska-Winiarska, Krystyna

(57) **Abstract**

The invention deals with a device for monitoring electric parameters such as current, voltage, active power, reactive power, apparent power, power factor and electric energy consumption in electric loads. The device according to the invention makes use of a single-phase or multi-phase electric socket (9) including its accessories, and an installation casing (1) or the casing of an electric extension cable (1'). The device is characterized in that it comprises a PCB (2) or (2') which is located respectively in the installation casing (1) or the casing of an electric extension cable (1') on which there is located an electronic system comprising at least one measuring sensor (4) connected through the electric circuit of the board (2,2') with a microcontroller (12) which is connected by the electric circuits of the board (2,2') with a non-volatile memory (13) which stores the measured data and historical data, and with an AC/DC converter (14), which are electrically interconnected, the microcontroller (12) being connected through the electric circuit of the board (2,2') with a communication module (10) which is connected through the electric circuit of the board (2,2') with the AC/DC converter (14) and wirelessly connected with an external receiver (11) of the communication module (10) located outside the electric socket (9).

## Description

The invention deals with a device for monitoring electric parameters such as current, voltage, active power, reactive power, apparent power, power factor and electric energy consumption in electric loads. Optionally, environmental parameters, such as temperature, air humidity or atmospheric pressure can be also monitored. The invention is applicable to indoor spaces in various classes of buildings.

Monitoring of electric energy consumption allows to identify the most loaded circuits of an electric system and then to connect electric loads in a way enabling an even load in individual branches. It is also possible to identify the loads with the largest power consumption, to determine the period when this consumption occurs and, if necessary, to reduce it by replacing the receiver with an equivalent with lower energy consumption.

### Prior art

There is known a household energy consumption monitoring system in which energy consumption is calculated on the basis of current and voltage measurement, and the whole system consists of a central unit and sensors functioning together with it. An example of such device is a Fibaro product called FIBARO Wall Plug, which is a remotely controlled switch used to switch electric equipment on and off, and which also has a function of measuring consumed energy by means of suitable sensors installed in the plug. Colour light of a crystal LED ring informs members of the household about the current load of the connected electric device. When the temperature exceeds 55°C, a built-in temperature sensor will alarm the user with flashing red light. The alarm will also be activated if the maximum allowed load of 2.5 kW is exceeded.

The sensors are made as plugs fitting standard electric sockets. Each plug is fitted with an electric socket enabling connection of an electric consumer to it. An electronic module responsible for measuring electric energy on the basis of the voltage and current input is built into the plug. Data from the sensors are transmitted from to the central unit responsible for processing, storage of historical data and communication with peripherals. Transmission of information to the central unit is wireless.

A drawback of that device is the necessity to have a central unit for storing data and enabling communication with peripheral devices. If the central unit fails, the whole system stops working and it is not possible to visualize historical data or to record the current measurement data in the memory of the central unit. Another drawback is the lack of internal memory in each sensor where measurement data could be stored in cases where there is no communication with the central unit. Storing data only in one central unit exposes the whole system to loss of the stored historical measurement data. In addition, the measuring system is located in a separate device placed between wall socket and the plug, which causes that the plug protrudes more from the wall and may cause collision with the room furniture. The device that sticks out of the socket is exposed to accidental damage.

### The essence of the invention

The essence of the device according to the invention is that it comprises a PCB which is contained in an installation casing or in the casing of an electric extension cable, on which there is located an electronic system comprising at least one measuring sensor connected through the electric circuit of the PCB to a microcontroller. The microcontroller is connected by the electric circuits of the PCB with a non-volatile memory which memorizes the measured data and the historical data, and with an AC/DC converter, which are electrically interconnnected. The microcontroller is connected through the electric circuit of the PCB with a communication module which is connected by the electric circuit of the PCB with the AC/DC converter and cordlessly connected with the external receiver of the communication module. The external receiver is located out of the electric socket of the device.

Preferably, the sensor located on the PCB is a current sensor.

Preferably, the PCB is fitted with additional voltage sensors and/or a sensor of non-electric quantities.

Preferably, the microcontroller is connected with an NFC (near field communication) module.

Preferably, the external receiver is a mobile phone or a tablet.

Preferably, the PCB is located in an installation casing that can be mounted in or on a wall of the building.

Alternatively, the PCB is located in the casing of an electric extension cable.

The extension cable comprising one or multiple electric sockets located in the casing of the extension cable and the external plug of the extension cable comprises the PCB according to claim 1-5.

### Advantages

The characteristic feature of the invention is the possibility of autonomous operation and a capability to record measurements in the internal memory without the participation of the central unit. In addition, the invention enables direct wireless communication, with a data visualizing device (Smartphone, tablet, etc). Processing and visualization of data from multiple devices is possible by means of an application which can be installed on any receiver such as a mobile phone. The application makes it possible to process and visualize data in a way defined by the user. Measuring data can be aggregated from multiple sensors and visualized as the summary energy consumption, for instance, for one room. It is also possible to show a consumer's share in total consumption Data visualization is not limited to one mobile device. Measuring data can be transmitted to many devices at the same time. The only requirement is an installation of the dedicated application. The device is characterized by the lack of a central source of supply, which causes that the number of devices connected to the system has no limit. The device is also distinguished by the fact that the measuring sensor is built into a typical electric socket and is invisible for the user. As each sensor operates autonomously, the system can be extended in a simple way and installation of any additional devices in the junction box is not required.

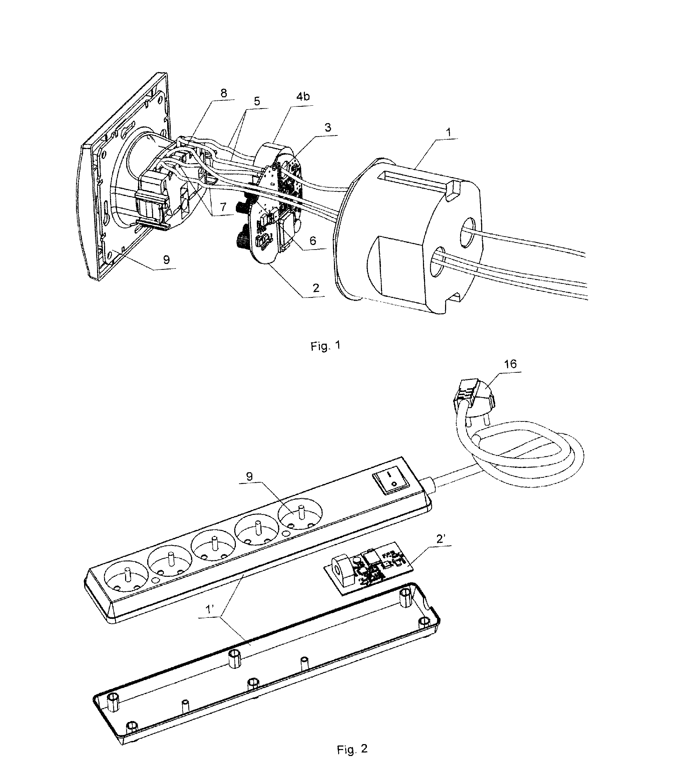

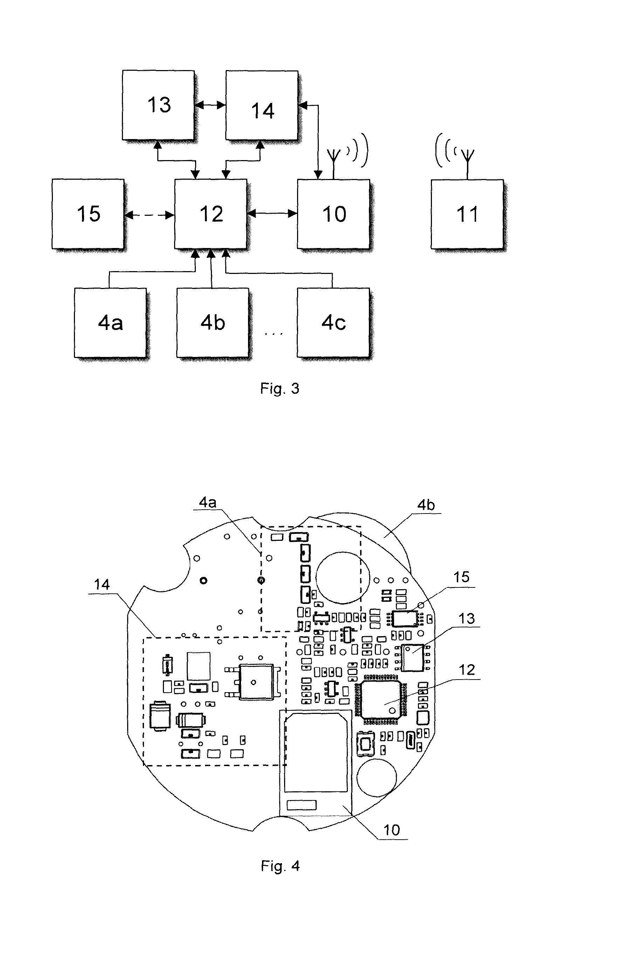

The device according to the invention is shown in the drawing, where fig. 1 shows the device for installation in a standard wall-type installation box in exploded view, fig. 2 - the device for installation in an electric extension cable in schematic depiction in exploded view, fig. 3 - a block diagram of the system for installation in the device from fig. 1 or 2, fig. 4 - the system installed on the board of the device from fig. 1 in schematic depiction, with a visualization of unmarked electronic components.

The device according to the invention has been designed for installation in a standard wall installation box intended for electric sockets, or in the casing of an electric extension cable. The device comprises an installation casing 1 for installing the casing on the wall or inside the wall, or in the casing of an extension cable 1'. Inside the installation casing 1 there is a PCB (printed circuit board) 2 on which an electronic system is located. In the casing of the extension cable 1' there is a PCB 2' on which an electronic system is located. The detailed description of the device is presented for the installation casing 1. In the board 2 there is an opening 3 on which a current sensor 4b is located. In the example of an embodiment the sensor is a current transformer 4b. A Hall effect sensor, a magnetoresistive sensor, or a GMR (giant magneto resistance) sensor can also be used as the current sensor. A phase conductor 5, in which phase current is measured, passes through the opening 3 in the board and the transformer. Additionally, in the board of the printed circuit there is a cut 6 through which a neutral wire 7 and a protective wire 8 is brought. The sensor is energised from the phase conductor 5 and the neutral wire 7 brought out from an electric socket 9.

A block diagram of the electronic system used in the invention is shown in fig. 3. The device consists of a communication module 10 which cordlessly transmits measuring data to a receiver 11. The receiver can be e.g. a mobile phone. The receiver has a data processing and visualizing application installed in it. The communication module is connected to a microcontroller 12 which is the central element of the electronic system. The following sensors are connected to the microcontroller: measuring sensors 4a, 4b, 4c enabling measurement of, respectively, voltage - sensor 4a, current - sensor 4b, or environmental parameters, such as temperature, humidity, etc. - sensor 4c. The microcontroller is connected with an electronic non-volatile memory 13 in which historical measuring data are stored. The electronic system is energized from an AC/DC converter 14. The converter converts alternating voltage 230V to direct voltage 5V. Additionally, an NFC interface 15 can be connected to the microcontroller, which is indicated by a dashed line in fig. 3. The interface enables cordless transmission of diagnostic data to short distances if the device is not energised from the supply network. Power is supplied to the NFC module by means of an external electromagnetic field, so it does not need to be energized from the electrical system. Fig. 1 depicts the arrangement of the system according to the invention on the board 2 of the device for monitoring electric parameters of electric loads connected to the single- or two-phase electric socket 9.

Fig. 2 shows an exploded view of the extension cable. The extension cable comprises a casing 1' in which a PCB 2', indicated only schematically, is installed. The board 2' contains an electronic system, the same as for board 1. The board 2' has a shape suitable for placing it in the casing 1' of the extension cable. The extension cable is fitted with an electric conduit with a plug 16.

The device according to the invention enables measurement of electric quantities such as: current, voltage, active power, reactive power, apparent power, power factor and other non-electric quantities, such as temperature, air humidity or atmospheric pressure depending of the type of medium or sensors mounted on the board 2 or 2'. Historical data are stored in the internal non-volatile memory 13 of the system and together with the current measuring data measured by measuring sensors 4a, 4b, and 4c are wirelessly transmitted to an application functioning in a mobile device, e.g. a cell phone 11. Data transmission from devices takes place on demand sent from the application. Electric current measurement is done by means of a current transformer 4b which converts the measured current to a value suitable for the microcontroller 12. Current measurement can be also achieved using a magnetoresistive sensor, a Hall effect sensor, GMR (giant magneto resistance) sensor, or other sensor. Voltage measurement is done by means of a voltage divider 4a, on which voltage proportional to the measured value is measured, after being reduced to a value suitable for the microcontroller. Active, reactive and apparent power, as well as power factor and energy consumption are calculated by means of an algorithm implemented in the internal software of the microcontroller 12. The analogue to digital converters of the microcontroller that process data from current and voltage measurements operate simultaneously. Visualization of measuring data is possible by means of a mobile application functioning on a mobile device, e.g. a cell phone 11. The application makes it possible to find all devices for monitoring electric parameters and optionally non-electric parameters, such as temperature, humidity, or atmospheric pressure, within the broadcast coverage, to establish communication with these devices, and taking the current and historical measuring data from them. The measuring data can be aggregated to allow presentation of statistics of energy consumption for predefined groups and for individual loads.

## Claims

1. A device making use of a single-phase or multi-phase electric socket (9) including its accessories and an installation casing (1) or the casing of an electric extension cable (1'), **characterized in that** it comprises a PCB (2) or (2') which is located respectively in the installation casing (1) or the casing of an electric extension cable (1') on which there is located an electronic system comprising at least one measuring sensor (4) connected through the electric circuit of the board (2,2') with a microcontroller (12) which is connected by the electric circuits of the board (2,2') with a non-volatile memory (13) which stores the measured data and historical data, and with an AC/DC converter (14), which are electrically interconnected, the microcontroller (12) being connected through the electric circuit of the board (2, 2') with a communication module (10) which is connected through the electric circuit of the board (2,2') with the AC/DC converter (14) and wirelessly connected with an external receiver (11) of the communication module (10) located outside the electric socket (9).

2. A device according to claim 1, **characterized in that** the sensor located on the PCB (2, 2') is a current sensor (4b).

3. A device according to claim 1, **characterized in that** the PCB (2, 2') is fitted with additional voltage sensors (4a) and/or a sensor of non-electric quantities (4c).

4. A device according to claim 1, **characterized in that** the microcontroller (12) is connected with an NFC module (15).

5. A device according to claim 1, **characterized in that** external receiver (11) is a mobile phone or a tablet.

6. A device according to claim 1, **characterized in that** the PCB (2) is located in the installation casing (1) suitable for mounting in or on a wall of a building.

7. A device according to claim 1, **characterized in that** the PCB (2') is located in the casing (1') of the electric extension cable.

8. An extension cable comprising one or multiple electric sockets (9) located in the casing of the extension cable (1') and an external plug (16) of the extension cable, **characterized in that** it comprises the PCB (2') according to claims 1-5.
